# EUROPEAN PATENT SPECIFICATION

(11) **EP 4 118 384 B1**
(45) Date of publication and mention of the grant of the patent: **13.12.2023**
(21) Application number: 20808189.3
(22) Date of filing: 30.10.2020
(51) Int. Cl.: F24F 5/00, F25B 25/00, H05K 7/20, F24F 3/00, F24F 11/32, F24F 11/46, F24F 11/65, F24F 11/83, F24F 11/84, F24F 11/85, F24F 110/12

(54) **FREECOOLING UNIT FOR TEMPERATURE MANAGEMENT SYSTEM**
FREECOOLING-EINHEIT FÜR TEMPERATURVERWALTUNGSSYSTEM
UNITÉ DE REFROIDISSEMENT LIBRE POUR SYSTÈME DE GESTION DE TEMPÉRATURE

(30) Priority: 12.03.2020 IT 202000005335
(43) Date of publication of application: 18.01.2023
(73) Proprietor: Stulz S.p.A., 37067 Valeggio sul Mincio (VR) (IT)
(72) Inventor: PEROTTI, Paolo, 37067 Valeggio sul Mincio (VR) (IT); POLCE, Alessandro, 37067 Valeggio sul Mincio (VR) (IT)
(74) Representative: Di Bernardo, Antonio
(86) International application number: PCT/IB2020/060201
(87) International publication number: WO 2021/181153

(56) References cited:
- EP-A1- 3 351 862
- CN-A- 106 895 525
- CN-A- 107 255 329
- CN-A- 107 990 454
- CN-A- 108 775 659
- CN-A- 110 186 130

## Description

### TECHNICAL FIELD

The present invention relates to the sector of managing the temperature of a heat load. In particular, the invention relates to a free cooling unit, or free cooler, a system for managing the temperature of a load comprising such free cooler and a corresponding method for controlling such temperature management system.

### BACKGROUND

Controlling the temperature of a heat load, in particular of an environment, is a crucial aspect to ensure a proper functioning of the devices operating in such environment - such as an industrial plant or a data centre - or an adequate comfort for people using such environment - for instance a large size building. In the case of a data centre, for instance, temperature variations even of few degrees may compromise the correct functioning of the processing and storage devices operating in such an environment.

The typical system for managing the temperature comprises a refrigerator unit, or chiller, the free cooler and an air cooling module, or dry cooler, or alternatively, an evaporative cooling tower. Typically, one or more of chiller, free cooler and dry cooler are formed as a single physical assembly, and, more in general, each model of chiller, free cooler and dry cooler is designed to operate with a specific model of the other units.

For instance, EP 3351862 discloses a HVAC system for buildings comprising a chiller, a heat exchanger separated from the chiller and a controller. The chiller provides a mechanical cooling to a load while functioning in a mechanical cooling state of the HVAC. The heat exchanger provides a free cooling to the load during a free cooling state of the HVAC. The controller is configured to predict the temperature of the external air and switch the functioning of the HVAC from the mechanical cooling state to the free cooling state when the predicted external air temperature is lower than a free cooling threshold for at least a minimum free cooling time.

In order to ensure a desired temperature of the heat load, the known management systems are configured so as to keep constant one between the inlet temperatures and outlet temperature of one or more fluids which are used to exchange heat with the heat load. Typically, the chiller is actuated to refrigerate a fluid that is transferred to the load whose temperature is to be controlled, whereas the dry cooler has the object of promoting the functioning of the chiller by transferring the heat to the external environment. The free cooler is actuated thermally in parallel with respect to the chiller to aid refrigerating the fluid to be transferred to the load when the external temperature is lower than the temperature of the fluid to be cooled.

The Applicant has observed that the known above described temperature management systems do not allow to maximise the energy efficiency of the system. In particular, the Applicant has observed that the energy consumptions of the known temperature management systems are ruled by the power necessary for pumping fluids through the system.

### OBJECTS AND SUMMARY OF THE INVENTION

An object of the present invention is to overcome the drawbacks of the prior art.

Particularly it is an object of the present invention to provide a free cooling unit, capable of exploiting efficiently the heat exchange with the external environment in order to reduce the consumptions of a temperature management system in which such unit is included.

Another object of the present invention is to provide a free cooling unit, a temperature management system and a method for controlling such system that enable to maximise the contribution given by the free cooling unit to the heat exchange.

These and other objects of the present invention are achieved by a device incorporating the features of the accompanying claims, which form an integral part of the present description.

An aspect of the present invention relates to a free cooling unit comprising:
- a heat exchanger configured to allow a heat exchange between a first fluid and a second fluid;
- a first pumping assembly configured to pump the first fluid through a first hydraulic circuit from a first inlet port of the unit to a first outlet port of the unit;
- a second pumping assembly configured to pump the second fluid through a second hydraulic circuit from a second inlet port of the unit to a second outlet port of the unit, and
- a control module configured to control the functioning of the unit.

Advantageously, the unit further comprises a diverter assembly arranged between the first pumping assembly and the heat exchanger and configured to switch between a first state in which the first fluid is directed through the heat exchanger before reaching the first outlet port and a second state in which the first fluid is directly directed to the first outlet port.

Furthermore, the control module is configured to switch the diverter assembly in the first state when an external ambient temperature is lower than a temperature of the second fluid entering the unit through the second inlet port reduced by a predetermined value and to switch the diverter assembly in the second state when the external ambient temperature is greater than or equal to the temperature of the second fluid entering the unit through the second inlet port reduced by the predetermined value.

Preferably, the predetermined value is comprised between 0° and 15° C, for instance equal to 5° C.

Thanks to such solution it is possible to take full advantage of the heat transfer obtained by the heat exchanger of the free cooling unit when the first fluid has a suitable temperature. Furthermore, the possibility to completely exclude the heat exchanger from the path of the first fluid allows to reduce the pressure drop experienced by the pump. Therefore, it is possible to reduce the consumptions of the pumps pushing the first fluid into the unit.

In one embodiment, the unit comprises a further diverter assembly arranged between the second pumping assembly and the second outlet port in parallel to the heat exchanger, said further diverter assembly being configured to switch between a first state in which the second fluid flows through the heat exchanger before reaching the second outlet port and a second state in which the second fluid is directly directed to the second outlet port.

Furthermore, the control module is, preferably, configured to switch the further diverter assembly into the first state when an external ambient temperature is lower than the temperature of the second fluid entering the unit through the second inlet port reduced by the predetermined value and to switch the further diverter assembly into the second state when the external ambient temperature is greater than or equal to the temperature of the second fluid entering the unit through the second inlet port reduced by the predetermined value.

It is thereby possible to selectively exclude the heat exchanger also from the circuit into which the second fluid flows, thereby obtaining a reduction of consumptions of the corresponding pump in a similar way to what above considered.

In one embodiment, the diverter assembly comprises:
- a first valve hydraulically connected in series with a discharge outlet of the first pumping assembly and in parallel with inlet and outlet ports of the heat exchanger through which the first fluid flows, and
- a second valve hydraulically connected in series with the discharge outlet of the first pumping assembly and in series with the inlet port of the heat exchanger through which the first fluid flows.

The diverter assembly thus formed is of easy and compact construction and further allows to define two paths for the first fluid controllable independently from each other.

Advantageously, in the first state of the diverter assembly the first valve is closed, while the second valve is open. By contrast, in the second state of the diverter assembly the first valve is open, while the second valve is closed.

The presence of two valves allows changing the operating state of the diverter assembly in a particularly simple and reliable way.

In one embodiment, the first pumping assembly comprises a first pump and a second pump hydraulically connected in parallel with each other.

Advantageously, when at least one between the first pump and second pump undergoes a malfunction, the control module is configured to switch the diverter assembly in an intermediate state between the first state and the second state. Preferably, in said intermediate state both the first valve and the second valve are at least partially open so as to ensure a sufficient flow of the first fluid in the first hydraulic circuit, at the same time, imposing a limitation as little as possible to the heat exchange performed by the free cooling unit.

Thanks to this solution the unit is more robust with respect to malfunctions of the first pumping assembly. In addition, by adjusting the valve opening, it is possible to control the pressure drop experienced by the pumping apparatus. Consequently, it is possible to ensure the proper functioning of the unit even in case of malfunctions and, at the same time, it is possible to exploit the free-type heat exchange within the limits allowed by the malfunctions of the first pumping assembly.

A different aspect of the present invention proposes a temperature management system of a load, comprising a unit exchanging heat with the external environment, a refrigerator unit and a free cooling unit according to any one of the above set forth embodiments.

Advantageously, the heat exchange unit for exchanging heat with the external environment, the refrigeration unit and the free cooling unit are hydraulically connected with each other to define a first hydraulic circuit into which the first fluid flows. Preferably, the first hydraulic circuit comprising the first pumping assembly, the first diverter assembly and the heat exchanger of the free cooling unit, a condenser of the refrigeration unit and a heat exchanger of the unit exchanging heat with the external environment. Furthermore, the refrigeration unit and the free cooling unit are hydraulically connected with each other to define a second hydraulic circuit in which the second fluid flows. Preferably, the second hydraulic circuit comprising the second pumping assembly, and the heat exchanger of the free cooling unit, and an evaporator of the refrigeration unit and, further, a heat exchanger associated to the load.

Such system allows optimally exploiting a difference between the external ambient temperature and the temperature of the second fluid used for cooling the system load. This therefore allows reducing the necessary contribution to the cooling by the refrigeration unit, or chiller of the system, with a consequent reduction of the system consumptions and operating costs.

In one embodiment, the heat exchange unit for exchanging heat with the external environment and the refrigeration unit comprise a respective control module. Advantageously, the control module of the free cooling unit is coupled with the control modules of the heat exchange unit for exchanging heat with the external environment and of the refrigeration unit and is configured to receive functioning data therefrom and provide functioning instructions thereto.

Thanks to such solution, the free cooling unit may be combined to refrigeration units and heat exchange units for exchanging heat with the external environment having different characteristics to efficiently constitute a system for managing the temperature of a load.

In one embodiment, the free cooling unit comprises a communication module configured to exchange data with the control modules of the heat exchange unit for exchanging heat with the external environment and of the refrigeration unit by a cabled communication or a wireless communication. Preferably, the communication module is configured to exchange data through Modbus protocol.

A different aspect of the present invention proposes a control method of a system for managing the temperature of a load.

In particular, the system defines:
- a first hydraulic circuit in which the first fluid flows, said first hydraulic circuit comprising a first pumping assembly, a diverter assembly, a heat exchanger for exchanging heat with the second fluid, a condenser for exchanging heat with the refrigerant fluid and a further heat exchanger for exchanging heat with the external environment;
- a second hydraulic circuit in which the second fluid flows, said second hydraulic circuit comprising a second pumping assembly, the heat exchanger for exchanging heat with the first fluid, an evaporator for exchanging heat with the refrigerant fluid and a heat exchanger associated with the load, and
- a cooling circuit in which the refrigerant flows. For example, the cooling circuit comprising a compressor, the condenser, a thermal expansion valve and the evaporator; alternatively, any other cooling circuit may be implemented, such as a circuit based on an adsorption cycle.

Advantageously, the method comprises:
- detecting an external ambient temperature and a temperature of the second fluid at the suction inlet of the second pumping assembly;
- determining whether the external ambient temperature is lower than the temperature of the second fluid at the suction inlet of the second pumping assembly reduced by a predetermined value;
- in the affirmative case, switching the diverter assembly to a first state in which the first fluid is directed through the heat exchanger before reaching the first outlet port, or
- in the negative case, switching the diverter assembly to a second state in which the first fluid is directly directed to the first outlet port.

Thanks to this solution it is possible to take full advantage of the heat transfer obtained by the heat exchanger of the free cooling unit when the first fluid has a suitable temperature similarly to what above considered for the free cooling unit.

In one embodiment, the second hydraulic circuit further comprises a further diverter assembly arranged between the second pumping assembly and the evaporator in parallel to the heat exchanger.

In this case, preferably, the method further comprises the steps of
- when the external ambient temperature is lower than the temperature of the second fluid at the suction inlet of the second pumping assembly reduced by a predetermined value, switching the further diverter assembly in a first state in which the second fluid is directed through the heat exchanger before reaching the evaporator, or
- when the external ambient temperature is equal to or greater than the temperature of the second fluid at the suction inlet of the second pumping assembly reduced by the predetermined value, switching the further diverter assembly in a second state in which the second fluid is directly directed to the evaporator.

Thanks to this solution it is possible to remove pressure drops related to the heat exchanger of the free cooler unit when the latter does not allow to reduce the temperature of the second fluid.

In one embodiment, the method comprises the step of:
- when the diverter assembly is in the first state, adjusting the functioning of the further heat exchanger so that the temperature of the second fluid leaving the latter reaches a value lower than a reference value of the second fluid.

Thereby the contribution to the heat exchange provided by the free cooling unit is maximised - allowed by the difference between the external ambient temperature (colder) and the load temperature (warmer). It is consequently possible to reduce the activity of the cooling circuit and, hence, the adsorbed power; furthermore, this makes it possible to reduce the wear of the components of the refrigerating circuit and the operating costs of the overall system thus controlled.

In one embodiment, the method comprises the step of:
- when the diverter assembly is in the first state, selecting a highest flow rate among:
   - a minimum operating flow rate allowed by the heat exchanger;
   - a minimum operating flow rate allowed by the further heat exchanger, and
   - a minimum operating flow rate allowed by the condenser.

Where minimum allowed operative flow rate means the minimum flow rate allowing the correct functioning of the corresponding element of the hydraulic circuit.

This selection of the flow rate ensures an efficient functioning of the system and, at the same time, allows to reduce the power adsorbed by the first pumping assembly with a consequent reduction of operating costs and wear of the pumping assembly.

In one embodiment, the first pumping assembly comprises two pumps connected between each other in parallel, while the diverter assembly comprises a first valve hydraulically connected in series to a discharge outlet of the two pumps and in parallel to inlet and outlet ports of the heat exchanger through which the first fluid flows, and a second valve hydraulically connected in series with a discharge outlet of the two pumps and in series with the inlet port of the heat exchanger through which the first fluid flows.

Thereby, the method comprises the further steps of:
- identifying a malfunction of one of the pumps of the first pumping assembly, and
- when a malfunction is identified, progressively bringing the first valve and the second valve to a partially open state in order to reduce the pressure drops experienced by the functioning pump.

Alternatively, the method comprises the following steps:
- identifying a malfunction of one of the pumps of the first pumping assembly;
- when a malfunction is identified, increasing the pumping speed of the functioning pump so as to reach a desired flow rate value of the first fluid, and
- in case a maximum pumping speed is reached before reaching the desired flow rate value of the first fluid,
- progressively bringing the first valve and the second valve to a partially open state in order to reach the desired flow rate of the first fluid.

Thanks to this solution it is possible to ensure a continuity in the temperature management and, at the same time, ensure to exploit, as much as possible, the heat exchange given by the difference between the external ambient temperature, substantially lower than the load temperature.

Further features and advantages of the present invention will be more evident from the description of the accompanying drawings.

### BRIEF DESCRIPTION OF THE DRAWINGS

The invention will be described below with reference to some examples, provided for explanatory and non-limiting purposes, and illustrated in the accompanying drawings. These drawings illustrate different aspects and embodiments of the present invention and, where appropriate, reference numerals illustrating similar structures, components, materials and/or elements in different figures are indicated by similar reference numbers.
Figure 1 is a simplified diagram of the hydraulic circuit of a temperature management system according to an embodiment of the present invention connected to a heat load;
Figure 2 is a simplified block diagram of the control electronics of the temperature management system of Figure 1;

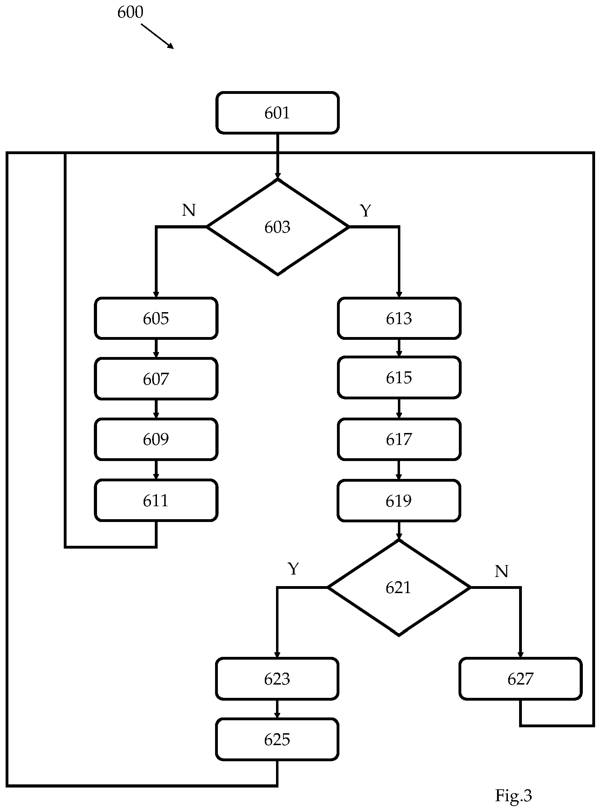

Figure 3 is a flow diagram of a control procedure of the system according to an embodiment of the present invention, and

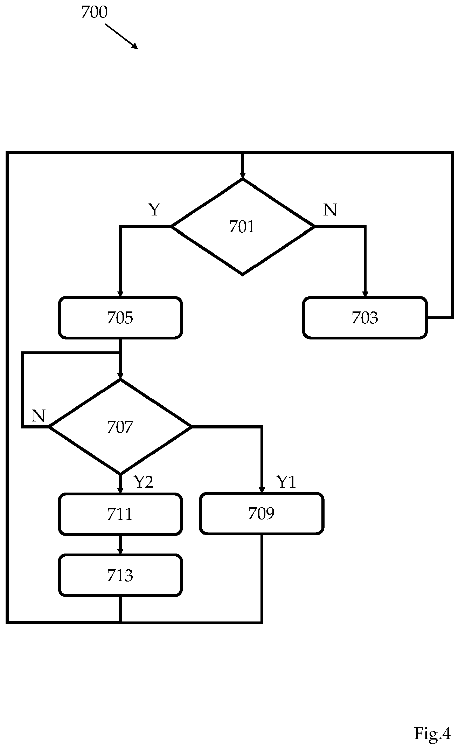

Figure 4 is a flow diagram of a safety procedure of the system according to an embodiment of the present invention.

### DETAILED DESCRIPTION OF THE INVENTION

While the invention is susceptible to various modifications and alternative constructions, certain preferred embodiments are shown in the drawings and are described hereinbelow in detail. It must in any case be understood that there is no intention to limit the invention to the specific embodiment illustrated, but, on the contrary, the invention intends covering all the modifications, alternative and equivalent constructions that fall within the scope of the invention as defined in the claims.

The use of "for example", "etc.", "or" indicates non-exclusive alternatives without limitation, unless otherwise indicated. The use of "includes" means "includes, but not limited to" unless otherwise stated.

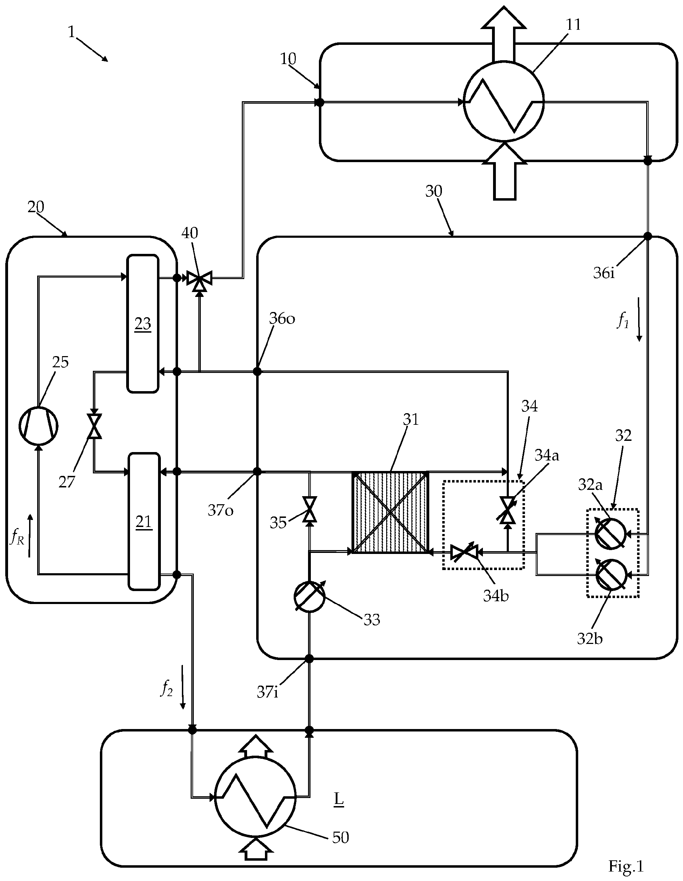

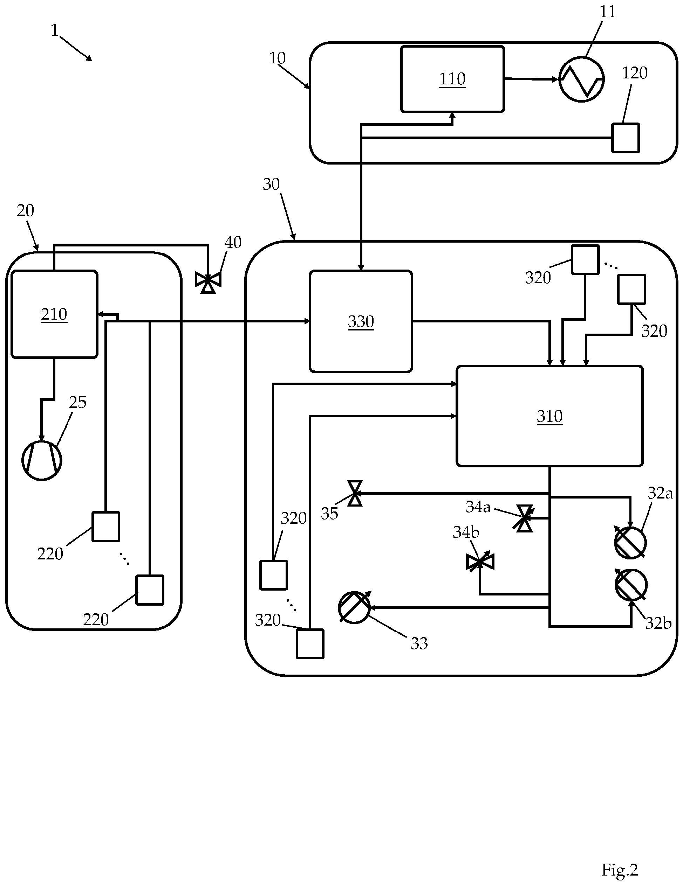

Referring to Figures 1 and 2, a temperature management system, briefly indicated hereinafter as 'system 1' is described, according to an embodiment of the present invention. The system 1 is configured to control a temperature TL of a load L, for instance a data centre in which it is desired to keep the inner temperature within a desired value or range of values Δ*T_{L}.*

The system 1 comprises an air cooling unit, or dry cooler 10, a refrigeration unit, or chiller 20 and a free cooling unit, or free cooler 30 and connected between each other hydraulically and electrically as hereinafter described.

The dry cooler 10 comprises an air/fluid heat exchanger 11 - for instance provided with one or more fans to force an air flow through a finned heat exchanger through which the first fluid f1 (e.g. water) passes.

The chiller 20 comprises an evaporator 21, a condenser 23, a compressor 25 and a thermal expansion valve 27, where such components are connected with each other to form a hydraulic circuit wherein the compressor 25 and the thermal expansion valve 27 are in parallel between evaporator 21 and condenser 23 (as shown in Figure 1), in order to allow a refrigerant fluid *f_{R}* (e.g., R-134a) to circulate.

Furthermore, an outlet port for the refrigerant liquid - the first fluid *f1* in the example considered - of the condenser 23 is, preferably, connected hydraulically to a three-way valve 40, while an outlet port for refrigerated liquid - a second fluid *f*2 (e.g. water) - of the evaporator 21 is, preferably, connected hydraulically to a heat exchanger 50 associated to the load L to exchange heat therewith - for example, the heat exchanger 50 may comprise one or more water/water exchanger (of the shell and tube, plate, immersed finned, coiled, tube in tube, tank or hydraulic collector type, etc.) or air/water heat exchanger (of the finned, fan coil, radiator type, etc.).

In the embodiments of the present invention the free cooler 30 comprises a heat exchanger 31, - for instance a plate heat exchanger - , a first pumping assembly 32, preferably comprising a pair of pumps 32a and 32b in parallel, at a variable flow rate and/or speed, a second pumping assembly 33, in the non-limiting example considered as comprising a single pump, at a variable flow rate and/or speed, a first diverter assembly 34, preferably comprising a pair of adjustable valves 34a, 34b, and a second diverter assembly 35, preferably comprising a valve.

Preferably, the suction inlets of the pumps 32a and 32b are hydraulically connected to a first inlet port 36i of the free cooler 30 - configured for the hydraulic connection to an outlet port of the dry cooler 10, to receive the first fluid *f1* -, while the discharge outlets of the pumps 32a and 32b are hydraulically connected to the diverter assembly 34. The diverter assembly 34 is hydraulically connected to a first inlet (refrigerant fluid inlet) of the heat exchanger 31 and to a first outlet port 36o of the free cooler 30 - which is connected to a condenser 23 inlet (refrigerant fluid inlet) of the chiller 20 and to the three-way valve 40 - to provide the first fluid *f1.* The same outlet port 36o is hydraulically connected to a first outlet (refrigerant fluid outlet) of the heat exchanger 31 from which the fluid *f1* exits after passing through the heat exchanger 31. In detail, one first valve 34a is interposed between the pumps 32a and 32b and the heat exchanger 31, while a second valve 34b is interposed between the pumps 32a and 32b and the outlet port 36o, with the first outlet of the heat exchanger 31 connected to the outlet port 36o, downstream of the second valve 32b.

Preferably, the pump suction inlet of the second pumping assembly 33, briefly hereinafter referred to as 'third pump 33', is hydraulically connected to a second inlet port 37i of the free cooler 30 - configured to be connected to the heat exchanger 50 associated to the load L, in order to receive the second fluid *f*2. The discharge outlet of the pump 33 is connected to a second inlet (refrigerated fluid inlet) of the heat exchanger 31 and to the valve of the second diverter assembly 35, briefly hereinafter referred to as 'third valve 35'. The third valve 35 and a second outlet (refrigerated fluid outlet) of the heat exchanger 31 are connected to a second outlet 37o of the free cooler 30 - configured to be connected to a refrigerated liquid inlet of the evaporator 21 of the chiller 20, so that the second fluid *f*2 passes through the evaporator 21 before being transferred to the load L.

Finally, the three-way valve 40 is connected to an inlet port of the dry cooler 10, so as to provide the first fluid *f1* entering the heat exchanger 11.

In function, the first cooling fluid *f1* circulates in a first hydraulic circuit defined by the pumps 32a and 32b, the valves 34a, 34b and 40, the heat exchangers 11 and 31, the three-way valve 40 and the condenser 23. In particular, the heat exchanger 31 of the free cooler 30 is placed in series with the condenser 23 of the chiller 20. By contrast, the refrigerant fluid *f_{R}* circulates in a cooling circuit defined by the condenser 23, the compressor 25, the evaporator 21 and the thermal expansion valve 27. Finally, the second fluid *f*2 circulates in a second hydraulic circuit defined by the third pump 33, the third valve 35, the heat exchangers 31 and 50 and the evaporator 21. In particular, the heat exchanger 31 of the free cooler 30 is placed in series with the evaporator 21 of the chiller 20.

As shown in the example of Figure 2, each of the units 10, 20 and 30 comprises one or more electronic and/or electromechanic components connected between each other to manage the operation of the system 1 in a substantially automatic way.

The dry cooler 10 preferably comprises an actuating module 110 comprising a circuit adapted to supply and control the rotation speed of the cooling fans. For example, the driving module 110 of the dry cooler 10 comprises a processing component - such as a micro-controller, a PLC, an ASIC, etcetera - and an actuating component - such as a power circuit configured to supply an electric motor of the fans. Advantageously, the dry cooler 10 also comprises a temperature sensor 120 configured to provide a signal indicative of the ambient temperature *Ta* outside the system 1 and the load L.

The chiller 20 preferably comprises a control module 210 comprising a circuit adapted to supply and control the compressor 25 functioning. For example, the control module 210 of the dry cooler 20 comprises a processing component - such as a micro-controller, a PLC, an ASIC, etcetera - and an actuating component - such as a power circuit configured to supply the compressor 25. In the embodiment being considered, the control module 210 is also configured to control the switching of the three-way valve 40. Advantageously, the chiller 20 also comprises a plurality of sensors 220 configured to measure functioning parameters of the chiller 20: such as a condenser temperature *T_{C}*, an evaporator temperature *T_{E}*, an evaporator inlet temperature *T*_{*f*2*E*} of the second fluid *f*2 which flows entering the evaporator, an outlet temperature *T*_{*f*2*L*} of the second fluid *f*2 which flows to the load L, etcetera.

The free cooler 30 comprises a control module 310 configured to supply and control the functioning of the pumps 32a, 32b and 33, and of the valves 34a, 34b and 35. For instance, the control module 310 of the free cooler 30 comprises a processing component - such as a micro-controller, a PLC, a micro-processor, a FPGA, an ASIC, etcetera - and an actuating component - such as a power circuit configured to supply and actuate the pumps 32a, 32b and 33, and the valves 34a, 34b and 35 based on instructions provided by the control module 310. Advantageously, the free cooler 30 also comprises a plurality of sensors 320 configured to provide the control module 310 with measures of operating parameters of the free cooler 20: such as a heat exchanger temperature *Ts*, an inlet temperature *T_{f1I}* and, optionally, an outlet temperature *T_{f1O}* of the first fluid *f1*, an inlet temperature *T*_{*f*2*I*} and, optionally, an outlet temperature *T*_{*j*2*O*} of the second fluid *f2* (substantially corresponding to the evaporator inlet temperature *T*_{*f*2*E*}), a flow rate of the first fluid *f1* and of the second fluid *f*2, etcetera.

In addition, the free cooler 30 according to the embodiment of the present invention comprises a communication module 330 electrically connected to the control module 310 of the free cooler 30, to the control module 210 of the chiller 20 and to the driving module 110 of the dry cooler 10, in order to allow a data exchange between the control module 310 of the free cooler 30 and the control modules 110 and 210 of the dry cooler 10 and of the chiller 20. For example, the communication module 330 is configured to connect to the modules 110 and 210 so as to exchange data by means of a known protocol, for example the Modbus protocol. Preferably, the communication module 310 is configured to provide functioning instructions to the control modules 110 and 120 and to receive measures acquired by the sensors 120 and 220 on-board the dry cooler 10 and the chiller 20.

Preferably, the control module 310 of the free cooler 30 is configured to control the functioning of the whole system 1 based on the measures acquired of the operating parameters of the system 1 - temperatures, flow rates, adsorbed electric powers, etcetera - in order to keep the load temperature *T_{L}* within the desired range of values *ΔT_{L}.* For that purpose, the control module 310 comprises a memory, preferably formed by both volatile and non-volatile portions, in which are stored functioning instructions, data acquired and/or generated during the operation etcetera.

Having described the structure of the system 1 according to the embodiment of the present invention, a control procedure 600 implemented by the system 1 will now be described.

Firstly, data provided by the sensors 120, 220 and 320 comprised in the system are acquired, in particular the external ambient temperature *Ta* and the inlet temperature *T*_{*f*2*I*} of the second fluid *f*2, (block 601) and it is verified if the external ambient temperature *Ta* is lower than the inlet temperature *T*_{*f*2*I*} of the second fluid *f*2 in the free cooler 30 - i.e., the temperature of the fluid returning from the load L - reduced by a predefined value, called approach *A_{T}* (decision block 603). Preferably the approach *A_{T}* value is comprised between 0° and 15° C, for instance equal to 5° C. In particular, the approach *A_{T}* is selected such to ensure that the heat exchanger 31 is able to promote an efficient heat exchange between the first fluid *f1* and the second fluid *f*2.

In the negative case (i.e. *Ta* ≥ *T*_{*f*2*I*} - *A_{T},* outlet branch N of the block 603), the valve 34b is closed, while the valves 34a and 35 are open, such to exclude the heat exchanger 31 from the hydraulic circuits - i.e. the first fluid *f1* and the second fluid *f*2 are prevented from flowing through the heat exchanger 31 (block 605).

Thereafter, the exchanger 11 of the dry cooler 10, in particular the rotation speed of the fans, is adjusted so as to keep substantially constant the inlet temperature *T_{f1I}* of the first fluid *f1* - i.e., the temperature of the first fluid *f1* at the inlet port 36i - (block 607). Alternatively, the exchanger 11 of the dry cooler 10 is adjusted such to keep substantially constant the return temperature of the first fluid *f1* downstream of the condenser 23 of the chiller 20. At the same time the pumps 32a and 32b are actuated so as to keep the nominal flow rate required by the condenser 23 of the chiller 20.

The compressor 25 of the chiller 20 is actuated such that the temperature of the second fluid *f*2 entering the load L - i.e., the outlet temperature *T*_{*f*2*L*} of the second fluid *f*2 exiting the evaporator of the chiller 20 - keeps substantially constant and equal to a desired value, or forward setpoint *T*_{*f*2 | *A*} such to ensure that the load temperature *T_{L},* is in turn comprised in the range of desired values *ΔT_{L}* (block 609). Preferably, the third pump 33 of the free cooler 30 is adjusted such to ensure a constant flow rate of the second fluid *f*2 and corresponding to a nominal flow rate required by the load 50. Alternatively, the compressor 25 is actuated such to maintain the temperature of the second fluid *f*2 exiting the load L substantially constant - i.e., the inlet temperature *T*_{*f*2*I*} of the second fluid *f*2 in the free cooler 30 - and equal to a desired value, or return setpoint *T*_{*f*2 | *R*} such to guarantee that the load temperature *T_{L},* is in turn comprised in the range of desired values *ΔT_{L}.*

Furthermore, the three-way valve 40 is controlled to deviate an amount of the first fluid *f1* coming from the free cooler 30 from the condenser 21 of the chiller 20, such to keep constant a condensation pressure inside the condenser 21 (block 611).

Thereafter, the procedure returns to the decision block 603 to monitor the external ambient temperature *Ta* in order to identify a reduction in the ambient temperature that is lower than the inlet temperature *T*_{*f*2*I*} of the second fluid *f*2 in the free cooler 30.

In case it is detected an external ambient temperature *Ta* lower than the inlet temperature *T*_{*f*2*I*} of the second fluid *f*2 in the free cooler 30 less the approach *A_{T}* (*Ta* < *T*_{*f*2*I*} - *A_{T},* outlet branch Y of the block 603), the valve 34b is opened, while the valves 34a and 35 are closed, such to force the first fluid *f1* and the second fluid *f*2 to flow through the heat exchanger 31 (block 613).

The heat exchanger 11 of the dry cooler 10 is configured to maximise the heat exchange between the first fluid *f1* and the external air (block 615). In the embodiments of the present invention, the heat exchanger 11 is controlled to maximise the heat exchange between the first flow *f1* and the second flow *f*2, in particular the heat exchanger 11 is actuated so that the inlet temperature of the second fluid *T*_{*f*2*I*} - returning from the load L - follows the return setpoint *T*_{*f*2 | *R*}. In a preferred embodiment, the heat exchanger 11 is adjusted such that the inlet temperature *T*_{*f*2*I*} of the second fluid *f*2 assumes a value below the return setpoint *T*_{*f*2 | *R*}, for instance lower than a difference value *dT* comprised between 0.5° and 5° C, for instance 1°C. In other words, the system 1 is adjusted to provide the maximum 'free' refrigerating yield available through the free cooler 30 and the dry-cooler 10.

The pumps 32a and 32b of the free cooler 30 are adjusted in such a way to minimise the difference in logarithmic average temperature or *ΔT_{ML}* between the first fluid *f1* and the external air to the heat exchanger of the dry cooler 10 at the external ambient temperature *Ta* (block 617). For this purpose, in one embodiment of the present invention, the pumps 32a and 32b are configured to operate with the flow rate *q̇* having the greatest value between the minimum operating flow rate *q̇*|_{1*min*} allowed by the heat exchanger 11 of the dry cooler 10, between the minimum operating flow rate *q̇*|_{2*min*} allowed by the condenser 23 of the chiller 20 and the the minimum operating flow rate *q̇*|_{3*min*} allowed by the heat exchanger 31 of the free cooler 30. Where minimum operating flow rate means the minimum flow rate of the first fluid *f1* which allows a proper heat exchange - i.e. such as to keep a turbulent regime of the first fluid passing through the exchangers 11 and 31, and the condenser 23; in other words the minimum flow rate selected prevents the fluid speed from decreasing too much leading to a laminar regime, with a consequent interruption of the heat exchange.

Preferably, the third pump 33 of the free cooler 30 is adjusted such to guarantee a constant flow rate of the second fluid *f*2 and corresponding to a nominal flow rate of the heat exchanger 50 associated to the load L (block 619).

Consequently, the compressor 25 of the chiller 20 is actuated only when the inlet temperature *T*_{*f*2*I*} of the second fluid *f*2 assumes a value greater than the return setpoint *T*_{*f*2 |} *_{R},* i.e. when it is detected that the outlet temperature *T*_{*f*2*L*} of the second fluid *f*2 provided entering the load L assumes a value greater than the forward setpoint T_{*f*2 | *A*} (decision block 621).

In case the outlet temperature *T*_{*f*2*L*} is greater than the forward setpoint *T*_{*f*2 | *A*} - and, therefore, the inlet temperature *T*_{*f*2*I*} is greater than the return setpoint *T*_{*f*2 | *R*} - (outlet branch Y of the block 621), the compressor 25 of the chiller 20 is controlled in order to change (reduce) the outlet temperature *T*_{*f*2*L*} of the second fluid *f*2 such to reach the forward setpoint T_{*f*2 | *A*} through the heat exchange to the evaporator 21 of the chiller 20 (block 623).

As above, the three-way valve 40 is controlled to deviate part of the first fluid *f1* from the condenser 21 of the chiller 20, if necessary, so as to keep a condensation pressure constant inside the condenser 21 (block 625).

In case the outlet temperature *T*_{*f*2*L*} is lower than or equal to the forward setpoint *T*_{*f*2 | *A*} - and, therefore, the inlet temperature *T*_{*f*2*I*} is lower than or equal to the return setpoint *T*_{*f*2 | *R*} - (outlet branch N of the block 621), the compressor 25 is not actuated, in other words, the chiller 20 is off and the management of the temperature *T_{L}* of the load L is merely obtained by controlling the functioning of the dry cooler 10 and of the free cooler 30 as above described (block 627).

Thereafter, the procedure returns to the decision block 603 to monitor the external ambient temperature *Ta.*

In one preferred embodiment, the system 1 is configured to carry out a safety procedure 700 to ensure a service continuity also in case of malfunction of the pumping assembly 32. In particular the safety procedure 700 detects when one of the pumps 32a and 32b undergoes a malfunction and ensures a continuity of the system 1 functioning during the malfunction and, possibly, during the repair/replacement/maintenance operations of one of the pumps 32a and 32b.

The procedure 700 provides to identify the onset of a malfunction condition in the pumps 32a and 32b during the functioning of the system 1 (decision block 701). For instance, a malfunction signal is detected as provided by the pump 32a or 32bla. Alternatively, a malfunction condition may be detected based on the detection of a variation or of an abnormal power adsorption value by one of the pumps 32a or 32b.

Unless a malfunction is detected (outlet branch N of the block 701), no action is undertaken apart from monitoring the state of the pumps 32a and 32b.

For merely exemplary purposes, reference is hereinafter made to the case in which the pump 32b undergoes a malfunction, while the pump 32a is still operating. Obviously, the same steps can be performed in the opposite case wherein the pump 32a breaks down, while the pump 32b is still operating.

When a malfunction of the pump 32b is detected and the external ambient temperature *Ta* is higher than the inlet temperature *T*_{*f*2*I*} of the second fluid *f*2 in the free cooler 30 less the approach *A_{T}* (*Ta* ≥ *T*_{*f*2*I*} - *A_{T}*) - i.e., the heat exchanger 31 of the free cooler 30 is isolated - (branch Y1 of the block 701), it is provided to increase the pumping speed of the functioning pump 32a until it reaches the desired flow rate value for the pumping assembly 32 or until reaching the maximum speed that the operating pump 32a can reach (block 703).

Thereafter, the operation monitors again the condition of the pumps 32a at block 701 to continue ensuring the continuity of the system 1 functioning until the malfunction is corrected.

When a malfunction of the pump 32b is detected and the external ambient temperature *Ta* is lower than the inlet temperature *T*_{*f*2*I*} of the second fluid *f*2 in the free cooler 30 less the approach *A_{T}* (*Ta* ≥ *T*_{*f*2*I*} - *A_{T}*) - i.e., the heat exchanger 31 of the free cooler 30 is connected in series with the chiller 20 condenser - (branch Y2 of the block 701), it is provided to increase the pumping speed of the functioning pump 32a until it reaches the desired flow rate value for the pumping assembly 32 or until reaching the maximum speed that the functioning pump 32a can reach (block 705).

Furthermore, it is provided to monitor the speed of the functioning pump 32a (decision block 707).

No action is undertaken apart from monitoring the speed and flow rate of the functioning pump 32a (outlet branch N of the block 707) until detection of the maximum speed value of the functioning pump 32a being reached.

Having detected that the minimum flow rate value is reached without having reached the maximum speed of the operating pump 32a (outlet branch Y1 of the block 707), it is provided to proceed controlling the temperature of the load L according to the above described procedure 600 (block 709) and it is provided to return to monitor the condition of the pumps 32a at the block 701 to continue ensuring the continuity of the system 1 functioning until the malfunction is corrected.

Having detected that the maximum speed is reached for the functioning pump 32a without having reached the minimum flow rate (outlet branch Y2 of the block 707), it is provided to gradually open the valve 34a and gradually close the valve 34b, in order to reduce pressure drops experienced by the pump 32a due to the heat exchanger 31 (block 711).

In this case the compressor 25 of the chiller 20 is actuated in a way substantially proportional to the valve opening 34a, so as to ensure that the outlet temperature *T*_{*f*2*L*} is substantially equal to the forward setpoint *T*_{*f*2 | *A*} - and, therefore, the inlet temperature *T*_{*f*2*I*} is lower than or equal to the return setpoint *T*_{*f*2 | *R*} - (block 713).

In other words, the opening of the valves 34a and 34b, as well as the functioning of the chiller 20 are modulated such to reduce the pressure drop experienced by the functioning pump 32a, so as to ensure a flow of the first minimum flow *f1* in the first hydraulic circuit allowing for the correct functioning of the system 1 and allowing to maintain the temperature T_{L} of the load L within the range d of desired values *ΔT_{L}.*

Thereafter, the operation monitors again the condition of the pumps 32a at block 701 to continue ensuring the continuity of the system 1 functioning until the malfunction is corrected.

The invention thus conceived is susceptible to several modifications and variations, all falling within the scope of the inventive concept.

For example, nothing prevents the first pumping assembly 32 from comprising a different number of pumps, such as a single pump or more than two pumps in parallel. Similarly, the second pumping assembly 33 may also comprise two or more pumps arranged in parallel between each other. In such case it may be provided a procedure for continuing the service which controls the functioning of the pumps of the second pumping assembly 33 in case of malfunction.

Furthermore, in alternative embodiments (not shown), the pumping assemblies 32 and 34 may be arranged downstream of the hydraulic exchanger with respect to the direction of flows *f1* e *f*2, hence with the suctions inlets connected with the respective outlet ports of the heat exchanger 31 and the discharge outlets connected to the outlet ports 36a and 37o, respectively, of the free cooler 30.

In one embodiment (not shown), the first diverter assembly 34 comprises a three-way valve rather than a pair of valves as described above in the embodiment shown.

Furthermore, it is possible to provide simplified embodiments (not shown) without the second diverter assembly.

It is possible to modify the free cooler 30 to comprise a third inlet port connected to a third outlet port, such to define a duct that allows connecting hydraulically the three-way valve 40 and the heat exchanger 11 of the dry cooler 10. Furthermore, the free cooler may be equipped with one or more flow rate and/or temperature sensors arranged in such duct, in order to monitor operating parameters of the first fluid *f1* in such a tract of the first hydraulic circuit.

In alternative to the dry cooler, the system according to other embodiments of the present invention (not shown) may comprise other heat exchange units for exchanging heat with the external environment, for instance a duly sized cooling tower, an evaporation tower, an adiabatic dry cooler, etcetera.

Furthermore, it is possible to provide a heat exchanger of the free cooler 30 different from a plate heat exchanger. For instance, in embodiments of the present invention (not shown), the free cooler may comprise any type of water/water exchanger (of the shell and tube, plate, immersed finned, coiled, tube in tube, tank or hydraulic collector type, etcetera).

In one alternative embodiment, the communication module may be configured to communicate with the chiller or dry cooler with a different protocol and/or by analog signals. Furthermore, the communication module may optionally provide wired or wireless means to communicate with a remote device. In such case the procedure for service continuity entails to transmit a malfunction signal to the remote device.

Obviously, alternative embodiments of the free cooler and/or of the whole system 1 may comprise additional hydraulic and/or electronic components such as exclusion valves, escape valves, one-way valves, user interfaces, flow rate sensors, pressure sensors, etcetera. In particular, alternative embodiments of the system 1 comprise one or more temperature sensors arranged on and/or inside the load in order to determine the load temperature T_{L} and/or variations thereof.

As will be clear to the skilled in the art, one or both of the above set forth procedures are comprised in a method for managing the temperature of a load. In addition, one or more steps of the same procedure or of different procedures may be performed in parallel between each other or according to an order different from the above described one. Similarly, one or more optional steps may be added or removed from one or more of the above described procedures. For example, the system 1, in particular the control module 310, may be configured to implement the operations described in blocks 605 to 611 of the parallel procedure 600 rather that in series. In addition or in alternative, also the operations described in blocks 613 to 619, and/or 623 and 625 may be performed in parallel rather than in series.

Optionally, the three-way valve 40 may be controlled to exclude the condenser 21 of the chiller 20, when the chiller 20 is not on.

Moreover, all the details can be replaced by other technically equivalent elements.

In particular, the cooling circuit may have a different structure. For example, in alternative embodiments (not shown) the cooling circuit may comprise an absorption cycle.

Furthermore, as will be clear to the skilled in the art, the connections between the control modules 110, 210 and 310 may be made by a wired and/or wireless communication channel.

In practice, the materials used, as well as the contingent shapes and sizes, can be whatever according to the requirements without for this reason departing from the scope of protection of the following claims.

## Claims

1. Free cooling unit (30) comprising:
- a first inlet port (36i);
- a first outlet port (36o);
- a second inlet port (37i);
- a second outlet port (37o);
- a heat exchanger (31), configured to allow a heat exchange between a first fluid and a second fluid;
- a first pumping assembly (32) configured to pump the first fluid through a first hydraulic circuit from the first inlet port (36i) of the unit (30) to a first outlet port (36o) of the unit (30);
- a second pumping assembly (33) configured to pump the second fluid through a second hydraulic circuit from the second inlet port (37i) of the unit (30) to the second outlet port (37o) of the unit (30), and
- a control module (310) configured to control the functioning of the unit (30), **characterised by**
further comprising a diverter assembly (34) arranged between the first pumping assembly (32) and the heat exchanger (31) and configured to switch between a first state in which the first fluid is directed through the heat exchanger (31) before reaching the first outlet port (36o) and a second state in which the first fluid is directly directed to the first outlet port (36o), and
in that
the control module (310) is configured to switch the diverter assembly (34) in the first state when an external ambient temperature is lower than a temperature of the second fluid entering the unit (30) through the second inlet port (37i) reduced by a predetermined value and for switching the diverter assembly (34) in the second state when the external ambient temperature is greater than or equal to the temperature of the second fluid entering the unit (30) through the second inlet port (37i) reduced by the predetermined value.

2. Unit (30) according to claim 1, comprising a further diverter assembly (35) arranged between the second pumping assembly (33) and the second outlet port (37o) in parallel to the heat exchanger, said further diverter assembly (35) being configured to switch between a first state in which the second fluid flows through the heat exchanger before reaching the second outlet port (37o) and a second state in which the second fluid is directly directed to the second outlet port (37o), and
wherein the control module (310) is configured to switch the further diverter assembly (35) into the first state when an external ambient temperature is lower than the temperature of the second fluid entering the unit (30) through the second inlet port (37i) reduced by the predetermined value and to switch the further diverter assembly (35) into the second state when the external ambient temperature is greater than or equal to the temperature of the second fluid entering the unit (30) through the second inlet port (37i) reduced by the predetermined value.

3. Unit (30) according to claim 1 or 2, wherein the diverter assembly (34) comprises:
- a first valve (34a) hydraulically connected in series with a discharge outlet of the first pumping assembly (34) and in parallel to inlet and outlet ports of the heat exchanger (31) through which the first fluid flows, and
- a second valve (34b) hydraulically connected in series with the discharge outlet of the first pumping assembly (34) and in series with the inlet port of the heat exchanger (31) through which the first fluid flows, and
wherein in the first state of the diverter assembly (32), the first valve (34a) is closed and the second valve (34b) is open, while in the second state of the diverter assembly (32) the first valve (34a) is open and the second valve (34b) is closed.

4. Unit (30) according to claim 2 or 3, wherein the first pumping assembly comprises a first pump (32a) and a second pump (32b) hydraulically connected in parallel with each other, and
wherein, when at least one between the first pump (32a) and the second pump (32b) undergoes a malfunction, the control module (310) is configured to switch the diverter assembly (34) in an intermediate state between the first state and the second state, in said intermediate state both the first valve (34a) and the second valve (34b) being at least partially open so as to reduce a pressure drop experienced by the first pumping assembly (32).

5. System (1) for managing the temperature of a load (L), comprising a heat exchange unit (10) for exchanging heat with the external environment, a refrigeration unit (20) and a free cooling unit (30) according to any one of the preceding claims,
wherein the heat exchange unit (10) for exchanging heat with the external environment, the refrigeration unit (20) and the free cooling unit (30) are hydraulically connected to each other to define a first hydraulic circuit in which the first fluid flows, said first hydraulic circuit comprising the first pumping assembly (32), the first diverter assembly (34) and the heat exchanger (31) of the free cooling unit (30), a condenser (23) of the refrigeration unit (20) and a heat exchanger (11) of the heat exchange unit (10), and
where the cooling unit (20) and the free cooling unit (30) are hydraulically connected to each other to define a second hydraulic circuit in which the second fluid flows, said second hydraulic circuit comprising the second pumping assembly (33), and the heat exchanger (31) of the free cooling unit (30), and an evaporator (21) of the refrigeration unit (20) and a heat exchanger (50) associated with the load (L).

6. System (1) according to claim 5, wherein the heat exchange unit (10) for exchanging heat with the external environment and the refrigeration unit (20) comprise a respective control module (110, 120), and
wherein the control module (310) of the free cooling unit (30) is coupled with the control modules (110, 120) of the heat exchange unit (10) for exchanging heat with the external environment and of the refrigeration unit (20) and is configured to receive operating data therefrom and provide operating instructions thereto.

7. Method (600; 700) for controlling a system (1) for managing the temperature of a load (L), the system (1) defining:
- a first hydraulic circuit in which a first fluid flows, said first hydraulic circuit comprising a first pumping assembly (32), a first diverter assembly (34), a heat exchanger (31) for exchanging heat with a second fluid, a condenser (23) for exchanging heat with a refrigerating fluid, and an additional heat exchanger (11) for exchanging heat with the external environment;
- a second hydraulic circuit in which the second fluid flows, said second hydraulic circuit comprising a second pumping assembly (33), the heat exchanger (31) for exchanging heat with the first fluid, an evaporator (21) for exchanging heat with the refrigerant fluid and a heat exchanger (50) associated with the load (L), and
- a cooling circuit in which the refrigerant flows,
wherein the method comprises:
- detecting (601) an external ambient temperature and a temperature of the second fluid at the suction of the second pumping assembly (33);
- determining (603) whether the external ambient temperature is lower than the temperature of the second fluid at the suction inlet of the second pumping assembly (33) reduced by a predetermined value;
- in the affirmative case, switching (613) the diverter assembly (34) to a first state in which the first fluid is directed through the heat exchanger (31) before reaching the first outlet port (36o), or
- in the negative case, switching (605) the diverter assembly (34) to a second state in which the first fluid is directly directed to the first outlet port (36o).

8. A method (600; 700) according to claim 7, wherein the second hydraulic circuit further comprises a further diverter assembly (35) arranged between the second pumping assembly (33) and the evaporator (21) in parallel to the heat exchanger of heat (31), and wherein the method (600) further comprises the steps of:
- when the external ambient temperature is lower than the temperature of the second fluid at the suction inlet of the second pumping assembly (33) reduced by a predetermined value, switching (613) the further diverter assembly (35) in a first state in which the second fluid is directed through the heat exchanger (31) before reaching the evaporator (21), or
- when the external ambient temperature is greater than or equal to the temperature of the second fluid at the suction inlet of the second pumping assembly (33) reduced by the predetermined value, switching (605) the further diverter assembly (35) in a second state in which the second fluid is directly directed to the evaporator (21).

9. Method (600; 700) according to claim 7 or 8, further comprising the step of:
- when the diverter assembly is in the first state, adjusting (615) the operation of the further heat exchanger (11) so that the temperature of the second fluid leaving the latter reaches a value lower than a reference value of the second fluid.

10. Method (600; 700) according to any one of the preceding claims 7 to 9, wherein
- the heat exchanger (31) is **characterized by** a minimum operating flow rate (*q̇*|_{3*min*}) allowed by the heat exchanger (31);
- the further heat exchanger (11) is **characterized by** a minimum operating flow rate (*q̇*|_{1*min*}) allowed by the further heat exchanger (11), and
- the condenser (23) is **characterized by** a minimum operating flow rate (*q̇*|_{2*min*}) allowed by the condenser (23), and
further comprising the step of:
- when the diverter assembly is in the first state, selecting (617) a highest flow rate among:
- a minimum operating flow rate (*q̇*|_{3*min*}) allowed by the heat exchanger (31);
- a minimum operating flow rate (*q̇*|_{1*min*}) allowed by the further heat exchanger (11), e
- a minimum operating flow rate(*q̇*|_{2*min*}) allowed by the condenser (23).

11. Method (600; 700) according to any one of the preceding claims 7 to 10, wherein the first pumping assembly comprises two pumps (32a, 32b) connected together in parallel, while the diverter assembly (34) comprises a first valve (34a) hydraulically connected in series with a delivery outlet of the two pumps (34a,34b) and in parallel to the inlet and outlet ports of the heat exchanger (31) through which the first fluid flows, and a second valve (34b) hydraulically connected in series with the delivery outlet of the two pumps (34a, 34b) and in series with the inlet port of the heat exchanger (31) through which the first fluid flows, and
wherein the method (700) comprises the further steps of:
- identifying (701) a malfunction of one of the pumps (32a, 32b) of the first pumping assembly (32), and
- when a malfunction is identified, progressively bringing (625) the first valve (34a) and the second valve (34b) to a partially open state in order to reduce the pressure drops experienced by the functioning pump (32a, 32b).

## Patentansprüche

1. Freikühleinheit (30) umfassend:
- eine erste Einlassöffnung (36i);
- eine erste Auslassöffnung (36o);
- eine zweite Einlassöffnung (37i);
- eine zweite Auslassöffnung (37o);
- einen Wärmetauscher (31) dazu konfiguriert einen Wärmeaustausch zwischen einem ersten Fluid und einem zweiten Fluid zu erlauben;
- eine erste Pumpanordnung (32) dazu konfiguriert das erste Fluid durch einen ersten Hydraulikkreislauf von der ersten Einlassöffnung (36i) der Einheit (30) zu einer ersten Auslassöffnung (36o) der Einheit (30) zu pumpen;
- eine zweite Pumpanordnung (33) dazu konfiguriert das zweite Fluid durch einen zweiten Hydraulikkreislauf von der zweiten Einlassöffnung (37i) der Einheit (30) zu der zweiten Auslassöffnung (37o) der Einheit (30) zu pumpen, und
- ein Steuermodul (310) dazu konfiguriert die Funktion der Einheit (30) zu steuern,
**dadurch gekennzeichnet, dass**
diese außerdem eine Umleitanordnung (34) umfasst, die zwischen der ersten Pumpanordnung (32) und dem Wärmetauscher (31) angeordnet ist und dazu konfiguriert ist, zwischen einem ersten Zustand, in dem das erste Fluid durch den Wärmetauscher (31) geleitet wird, bevor es die erste Auslassöffnung (36o) erreicht, und einem zweiten Zustand, in dem das erste Fluid direkt zur ersten Auslassöffnung (36o) geleitet wird, umzuschalten, und
dadurch, dass
das Steuermodul (310) dazu konfiguriert ist, die Umleitungsanordnung (34) in den ersten Zustand zu schalten, wenn eine äußere Umgebungstemperatur niedriger als eine Temperatur des zweiten Fluids, das in die Einheit (30) durch die zweite Einlassöffnung (37i) eintritt, verringert um einen vorbestimmten Wert ist, und die Umleitungsanordnung (34) in den zweiten Zustand zu schalten, wenn die äußere Umgebungstemperatur größer als oder gleich der Temperatur des zweiten Fluids, das in die Einheit (30) durch die zweite Einlassöffnung (37i) eintritt, verringert um den vorbestimmten Wert ist.

2. Einheit (30) nach Anspruch 1, umfassend eine weitere Umleitanordnung (35), die zwischen der zweiten Pumpanordnung (33) und der zweiten Auslassöffnung (37o) parallel zu dem Wärmetauscher angeordnet ist, diese weitere Umleitanordnung (35) dazu konfiguriert ist, zwischen einem ersten Zustand, in dem das zweite Fluid durch den Wärmetauscher strömt, bevor es die zweite Auslassöffnung (37o) erreicht, und einem zweiten Zustand, in dem das zweite Fluid direkt zu der zweiten Auslassöffnung (37o) geleitet wird, umzuschalten und
wobei das Steuermodul (310) dazu konfiguriert ist, die weitere Umleitanordnung (35) in den ersten Zustand zu schalten, wenn eine äußere Umgebungstemperatur niedriger als die Temperatur des zweiten Fluids, das in die Einheit (30) durch die zweite Einlassöffnung (37i) eintritt, reduziert um den vorbestimmten Wert ist, und die weitere Umleitanordnung (35) in den zweiten Zustand zu schalten, wenn die äußere Umgebungstemperatur größer als oder gleich der Temperatur des zweiten Fluids, das in die Einheit (30) durch die zweite Einlassöffnung (37i) eintritt, reduziert um den vorbestimmten Wert ist.

3. Einheit (30) nach Anspruch 1 oder 2, wobei die Umleitanordnung (34) umfasst:
- ein erstes Ventil (34a), das hydraulisch in Reihe mit einem Auslass der ersten Pumpanordnung (34) und parallel zu den Einlass- und Auslassöffnungen des Wärmetauschers (31), durch den das erste Fluid strömt, verbunden ist, und
- ein zweites Ventil (34b), das hydraulisch in Reihe mit dem Auslass der ersten Pumpanordnung (34) und in Reihe mit der Einlassöffnung des Wärmetauschers (31), durch den das erste Fluid fließt, verbunden ist, und
wobei in dem ersten Zustand der Umleitanordnung (32) das erste Ventil (34a) geschlossen und das zweite Ventil (34b) geöffnet ist, während in dem zweiten Zustand der Umleitanordnung (32) das erste Ventil (34a) geöffnet und das zweite Ventil (34b) geschlossen ist.

4. Einheit (30) nach Anspruch 2 oder 3, wobei die erste Pumpanordnung eine erste Pumpe (32a) und eine zweite Pumpe (32b), die hydraulisch miteinander parallel verbunden sind, umfasst, und
wobei, wenn mindestens eine der ersten Pumpe (32a) und der zweiten Pumpe (32b) eine Fehlfunktion aufweist, das Steuermodul (310) dazu konfiguriert ist, die Umleitanordnung (34) in einen Zwischenzustand zwischen dem ersten Zustand und dem zweiten Zustand zu schalten, in diesem Zwischenzustand sowohl das erste Ventil (34a) als auch das zweite Ventil (34b) zumindest teilweise geöffnet sind, um einen von der ersten Pumpanordnung (32) erfahrenen Druckabfall zu reduzieren.

5. System (1) zur Regelung der Temperatur einer Last (L), umfassend eine Wärmetauschereinheit (10) zum Austausch von Wärme mit der äußeren Umgebung, eine Kühleinheit (20) und eine Freikühleinheit (30) nach einem der vorhergehenden Ansprüche,
wobei die Wärmetauschereinheit (10) zum Austausch von Wärme mit der äu-ßeren Umgebung, die Kühleinheit (20) und die Freikühleinheit (30) hydraulisch miteinander verbunden sind, um einen ersten hydraulischen Kreislauf zu definieren, in dem das erste Fluid fließt, dieser erste hydraulische Kreislauf die erste Pumpanordnung (32), die erste Umleitanordnung (34) und den Wärmetauscher (31) der Freikühleinheit (30), einen Kondensator (23) der Kühleinheit (20) und einen Wärmetauscher (11) der Wärmetauschereinheit (10) umfasst, und
wobei die Kühleinheit (20) und die Freikühleinheit (30) hydraulisch miteinander verbunden sind, um einen zweiten hydraulischen Kreislauf zu definieren, in dem das zweite Fluid fließt, dieser zweite hydraulische Kreislauf die zweite Pumpeinheit (33) und den Wärmetauscher (31) der Freikühleinheit (30) und einen Verdampfer (21) der Kühleinheit (20) und einen Wärmetauscher (50) verbunden mit der Last (L) umfasst.

6. System (1) nach Anspruch 5, wobei die Wärmetauschereinheit (10) zum Austausch von Wärme mit der äußeren Umgebung und die Kühleinheit (20) ein zugehöriges Steuermodul (110, 120) aufweisen, und
wobei das Steuermodul (310) der Freikühleinheit (30) mit den Steuermodulen (110, 120) der Wärmetauschereinheit (10) zum Austausch von Wärme mit der äußeren Umgebung und von der Kühleinheit (20) gekoppelt ist und dazu konfiguriert ist, Betriebsdaten von dort zu empfangen und Betriebsanweisungen dorthin zu übermitteln.

7. Verfahren (600; 700) zur Steuerung eines Systems (1) zur Regelung der Temperatur einer Last (L), das System (1) definierend:
- einen ersten hydraulischen Kreislauf, in dem ein erstes Fluid zirkuliert, dieser erste hydraulische Kreislauf umfassend eine erste Pumpanordnung (32), eine erste Umleitanordnung (34), einen Wärmetauscher (31) zum Austausch von Wärme mit einem zweiten Fluid, einen Kondensator (23) zum Austausch von Wärme mit einem Kühlfluid und einen zusätzlichen Wärmetauscher (11) zum Austausch von Wärme mit der äußeren Umgebung;
- einen zweiten Hydraulikkreislauf, in dem das zweite Fluid strömt, dieser zweite Hydraulikkreislauf umfassend eine zweite Pumpanordnung (33), den Wärmetauscher (31) zum Austausch von Wärme mit dem ersten Fluid, einen Verdampfer (21) zum Austausch von Wärme mit dem Kühlfluid und einen Wärmetauscher (50) verbunden mit der Last (L), und
- einen Kühlkreislauf, in dem das Kühlfluid fließt,
wobei das Verfahren umfasst:
- Erfassen (601) einer äußeren Umgebungstemperatur und einer Temperatur des zweiten Fluids an der Ansaugung der zweiten Pumpanordnung (33);
- Bestimmen (603), ob die äußere Umgebungstemperatur niedriger als die Temperatur des zweiten Fluids am Saugeinlass der zweiten Pumpenbaugruppe (33) reduziert um einen vorbestimmten Wert ist;
- im positiven Fall, Umschalten (613) der Umleitanordnung (34) in einen ersten Zustand, in dem das erste Fluid durch den Wärmetauscher (31) geleitet wird, bevor es die erste Auslassöffnung (36o) erreicht, oder
- im negativen Fall, Umschalten (605) der Umleitanordnung (34) in einen zweiten Zustand, in dem das erste Fluid direkt zur ersten Auslassöffnung (36o) geleitet wird.

8. Verfahren (600; 700) nach Anspruch 7, wobei der zweite Hydraulikkreislauf ferner eine weitere Umleitanordnung (35), die zwischen der zweiten Pumpanordnung (33) und dem Verdampfer (21) parallel zum Wärmetauscher (31) angeordnet ist, umfasst, und wobei das Verfahren (600) ferner die Schritte umfasst:
- wenn die äußere Umgebungstemperatur niedriger als die Temperatur des zweiten Fluids am Saugeinlass der zweiten Pumpanordnung (33) verringert um einen vorbestimmten Wert ist, Schalten (613) der weiteren Umleitanordnung (35) in einen ersten Zustand, in dem das zweite Fluid durch den Wärmetauscher (31) geleitet wird, bevor es den Verdampfer (21) erreicht, oder
- wenn die äußere Umgebungstemperatur größer als oder gleich der Temperatur des zweiten Fluids am Saugeinlass der zweiten Pumpanordnung (33) verringert um den vorbestimmten Wert ist, Schalten (605) der weiteren Umleitanordnung (35) in einen zweiten Zustand, in dem das zweite Fluid direkt zum Verdampfer (21) geleitet wird.

9. Verfahren (600; 700) nach Anspruch 7 oder 8, ferner umfassend den Schritt:
- wenn sich die Umleitanordnung im ersten Zustand befindet, Einstellen (615) des Betriebs des weiteren Wärmetauschers (11), sodass die Temperatur des zweiten Fluids, das letzteren verlässt, einen Wert niedriger als einen Referenzwert des zweiten Fluids erreicht.

10. Verfahren (600; 700) nach einem der vorhergehenden Ansprüche 7 bis 9, wobei
- der Wärmetauscher (31) **gekennzeichnet ist durch** eine minimale Betriebsflussrate (*q̇*| *₃ₘᵢₙ*), die vom Wärmetauscher (31) zugelassen ist;
- der weitere Wärmetauscher (11) **gekennzeichnet ist durch** eine minimale Betriebsflussrate (*q̇*| *₁ₘᵢₙ*), die vom weiteren Wärmetauscher (11) zugelassen ist, und
- der Kondensator (23) **gekennzeichnet ist durch** eine minimale Betriebsflussrate (*q̇*| *₂ₘᵢₙ*), die vom den Kondensator (23) zugelassen ist, und
ferner umfassend den Schritt:
- wenn die Umleitanordnung im ersten Zustand ist, Auswählen (617) einer höchsten Flussrate aus:
- einer minimalen Betriebsflussrate (*q̇*| *₃ₘᵢₙ*), die vom Wärmetauscher (31) zugelassen ist;
- einer minimalen Betriebsflussrate (*q̇*| *₁ₘᵢₙ*), die vom weiteren Wärmetauscher (11) zugelassen ist, e
- einer minimalen Betriebsflussrate (*q̇*| *₂ₘᵢₙ*), die vom Kondensator (23) zugelassen ist.

11. Verfahren (600; 700) nach einem der vorhergehenden Ansprüche 7 bis 10, wobei die erste Pumpanordnung zwei miteinander parallel verbundene Pumpen (32a, 32b) umfasst, während die Umleitanordnung (34) ein erstes Ventil (34a), das hydraulisch in Reihe mit einem Förderauslass der beiden Pumpen (34a, 34b) und parallel zu den Einlass- und Auslassöffnungen des Wärmetauschers (31), durch den das erste Fluid strömt, verbunden ist und ein zweites Ventil (34b), das hydraulisch in Reihe mit dem Förderauslass der beiden Pumpen (34a, 34b) und in Reihe mit der Einlassöffnung des Wärmetauschers (31), durch den das erste Fluid strömt, verbunden umfasst, und
wobei das Verfahren (700) die weiteren Schritte umfasst:
- Identifizieren (701) einer Fehlfunktion von einer der Pumpen (32a, 32b) der ersten Pumpanordnung (32), und
- wenn eine Fehlfunktion identifiziert wird, schrittweises Bringen (625) des ersten Ventils (34a) und des zweiten Ventils (34b) in einen teilweise geöffneten Zustand, um die von der funktionierenden Pumpe (32a, 32b) erfahrenen Druckabfälle zu reduzieren.

## Revendications

1. - Unité de refroidissement naturel (30) comprenant :
- un premier orifice d'entrée (36i) ;
- un premier orifice de sortie (36o) ;
- un second orifice d'entrée (37i) ;
- un second orifice de sortie (37o) ;
- un échangeur de chaleur (31), configuré pour autoriser un échange de chaleur entre un premier fluide et un second fluide ;
- un premier ensemble de pompage (32) configuré pour pomper le premier fluide à travers un premier circuit hydraulique du premier orifice d'entrée (36i) de l'unité (30) à un premier orifice de sortie (36o) de l'unité (30) ;
- un second ensemble de pompage (33) configuré pour pomper le second fluide à travers un second circuit hydraulique du second orifice d'entrée (37i) de l'unité (30) au second orifice de sortie (37o) de l'unité (30), et
- un module de commande (310) configuré pour commander le fonctionnement de l'unité (30),
**caractérisée par le fait**
**qu'**elle comprend en outre un ensemble de déviation (34) disposé entre le premier ensemble de pompage (32) et l'échangeur de chaleur (31) et configuré pour commuter entre un premier état, dans lequel le premier fluide est dirigé à travers l'échangeur de chaleur (31) avant d'atteindre le premier orifice de sortie (36o), et un second état dans lequel le premier fluide est directement dirigé jusqu'au premier orifice de sortie (36o), et
par le fait que
le module de commande (310) est configuré pour commuter l'ensemble de déviation (34) sur le premier état lorsqu'une température ambiante externe est inférieure à une température du second fluide entrant dans l'unité (30) à travers le second orifice d'entrée (37i) réduite d'une valeur prédéterminée et pour commuter l'ensemble de déviation (34) sur le second état lorsque la température ambiante externe est supérieure ou égale à la température du second fluide entrant dans l'unité (30) à travers le second orifice d'entrée (37i) réduite de la valeur prédéterminée.

2. - Unité (30) selon la revendication 1, comprenant un ensemble de déviation supplémentaire (35) disposé entre le second ensemble de pompage (33) et le second orifice de sortie (37o) en parallèle de l'échangeur de chaleur, ledit ensemble de déviation supplémentaire (35) étant configuré pour commuter entre un premier état, dans lequel le second fluide s'écoule à travers l'échangeur de chaleur avant d'atteindre le second orifice de sortie (37o) et un second état dans lequel le second fluide est directement dirigé jusqu'au second orifice de sortie (37o), et
dans laquelle le module de commande (310) est configuré pour commuter l'ensemble de déviation supplémentaire (35) sur le premier état lorsqu'une température ambiante externe est inférieure à la température du second fluide entrant dans l'unité (30) à travers le second orifice d'entrée (37i) réduite de la valeur prédéterminée et pour commuter l'ensemble de déviation supplémentaire (35) sur le second état lorsque la température ambiante externe est supérieure ou égale à la température du second fluide entrant dans l'unité (30) à travers le second orifice d'entrée (37i) réduite de la valeur prédéterminée.

3. - Unité (30) selon la revendication 1 ou 2, dans laquelle l'ensemble de déviation (34) comprend :
- une première vanne (34a) reliée hydrauliquement en série à une sortie de refoulement du premier ensemble de pompage (34) et en parallèle à des orifices d'entrée et de sortie de l'échangeur de chaleur (31) à travers lesquels le premier fluide s'écoule, et
- une seconde vanne (34b) reliée hydrauliquement en série à la sortie de refoulement du premier ensemble de pompage (34) et en série à l'orifice d'entrée de l'échangeur de chaleur (31) à travers lequel le premier fluide s'écoule, et
dans laquelle, dans le premier état de l'ensemble de déviation (32), la première vanne (34a) est fermée et la seconde vanne (34b) est ouverte tandis que, dans le second état de l'ensemble de déviation (32), la première vanne (34a) est ouverte et la seconde vanne (34b) est fermée.

4. - Unité (30) selon la revendication 2 ou 3, dans laquelle le premier ensemble de pompage comprend une première pompe (32a) et une seconde pompe (32b) reliées hydrauliquement en parallèle l'une à l'autre, et
dans laquelle, lorsqu'au moins une parmi la première pompe (32a) et la seconde pompe (32b) subit un dysfonctionnement, le module de commande (310) est configuré pour commuter l'ensemble de déviation (34) dans un état intermédiaire entre le premier état et le second état, dans ledit état intermédiaire la première vanne (34a) et la seconde vanne (34b) étant toutes deux au moins partiellement ouvertes de façon à réduire une chute de pression subie par le premier ensemble de pompage (32).

5. - Système (1) de gestion de la température d'une charge (L), comprenant une unité d'échange de chaleur (10) pour échanger de la chaleur avec l'environnement externe, une unité de réfrigération (20) et une unité de refroidissement naturel (30) selon l'une quelconque des revendications précédentes,
dans lequel l'unité d'échange de chaleur (10) pour échanger de la chaleur avec l'environnement externe, l'unité de réfrigération (20) et l'unité de refroidissement naturel (30) sont reliées hydrauliquement les unes aux autres pour définir un premier circuit hydraulique dans lequel le premier fluide s'écoule, ledit premier circuit hydraulique comprenant le premier ensemble de pompage (32), le premier ensemble de déviation (34) et l'échangeur de chaleur (31) de l'unité de refroidissement naturel (30), un condenseur (23) de l'unité de réfrigération (20) et un échangeur de chaleur (11) de l'unité d'échange de chaleur (10), et
dans lequel l'unité de refroidissement (20) et l'unité de refroidissement naturel (30) sont reliées hydrauliquement l'une à l'autre pour définir un second circuit hydraulique dans lequel le second fluide s'écoule, ledit second circuit hydraulique comprenant le second ensemble de pompage (33), et l'échangeur de chaleur (31) de l'unité de refroidissement naturel (30), et un évaporateur (21) de l'unité de réfrigération (20) et un échangeur de chaleur (50) associé à la charge (L).

6. - Système (1) selon la revendication 5, dans lequel l'unité d'échange de chaleur (10) pour échanger de la chaleur avec l'environnement externe et l'unité de réfrigération (20) comprennent un module de commande respectif (110, 120), et dans lequel le module de commande (310) de l'unité de refroidissement naturel (30) est couplé aux modules de commande (110, 120) de l'unité d'échange de chaleur (10) pour échanger de la chaleur avec l'environnement externe et de l'unité de réfrigération (20) et est configuré pour recevoir des données de fonctionnement en provenance de ceux-ci et leur fournir des instructions de fonctionnement.

7. - Procédé (600 ; 700) pour commander un système (1) de gestion de la température d'une charge (L), le système (1) définissant :
- un premier circuit hydraulique dans lequel un premier fluide s'écoule, ledit premier circuit hydraulique comprenant un premier ensemble de pompage (32), un premier ensemble de déviation (34), un échangeur de chaleur (31) pour échanger de la chaleur avec un second fluide, un condenseur (23) pour échanger de la chaleur avec un fluide frigorigène, et un échangeur de chaleur supplémentaire (11) pour échanger de la chaleur avec l'environnement externe ;
- un second circuit hydraulique dans lequel le second fluide s'écoule, ledit second circuit hydraulique comprenant un second ensemble de pompage (33), l'échangeur de chaleur (31) pour échanger de la chaleur avec le premier fluide, un évaporateur (21) pour échanger de la chaleur avec le fluide frigorigène, et un échangeur de chaleur (50) associé à la charge (L), et
- un circuit de refroidissement dans lequel le fluide frigorigène s'écoule,
le procédé comprenant :
- détecter (601) une température ambiante externe et une température du second fluide à l'aspiration du second ensemble de pompage (33) ;
- déterminer (603) si la température ambiante externe est inférieure à la température du second fluide à l'entrée d'aspiration du second ensemble de pompage (33) réduite d'une valeur prédéterminée ;
- dans l'affirmative, commuter (613) l'ensemble de déviation (34) sur un premier état dans lequel le premier fluide est dirigé à travers l'échangeur de chaleur (31) avant d'atteindre le premier orifice de sortie (36o), ou
- dans la négative, commuter (605) l'ensemble de déviation (34) sur un second état dans lequel le premier fluide est directement dirigé jusqu'au premier orifice de sortie (36o).

8. - Procédé (600 ; 700) selon la revendication 7, dans lequel le second circuit hydraulique comprend en outre un ensemble de déviation supplémentaire (35) disposé entre le second ensemble de pompage (33) et l'évaporateur (21) en parallèle à l'échangeur de chaleur (31), et le procédé (600) comprenant en outre les étapes :
- lorsque la température ambiante externe est inférieure à la température du second fluide à l'entrée d'aspiration du second ensemble de pompage (33) réduite d'une valeur prédéterminée, commuter (613) l'ensemble de déviation supplémentaire (35) sur un premier état dans lequel le second fluide est dirigé à travers l'échangeur de chaleur (31) avant d'atteindre l'évaporateur (21), ou
- lorsque la température ambiante externe est supérieure ou égale à la température du second fluide à l'entrée d'aspiration du second ensemble de pompage (33) réduite de la valeur prédéterminée, commuter (605) l'ensemble de déviation supplémentaire (35) sur un second état dans lequel le second fluide est directement dirigé jusqu'à l'évaporateur (21).

9. - Procédé (600; 700) selon la revendication 7 ou 8, comprenant en outre l'étape :
- lorsque l'ensemble de déviation est dans le premier état, régler (615) le fonctionnement de l'échangeur de chaleur supplémentaire (11) de telle sorte que la température du second fluide quittant ce dernier atteint une valeur inférieure à une valeur de référence du second fluide.

10. - Procédé (600 ; 700) selon l'une quelconque des revendications précédentes 7 à 9, dans lequel
- l'échangeur de chaleur (31) est **caractérisé par** un débit de fonctionnement minimum (*q̇*|*₃ₘᵢₙ*) autorisé par l'échangeur de chaleur (31) ;
- l'échangeur de chaleur supplémentaire (11) est **caractérisé par** un débit de fonctionnement minimum (*q̇*|*₁ₘᵢₙ*) autorisé par l'échangeur de chaleur supplémentaire (11), et
- le condenseur (23) est **caractérisé par** un débit de fonctionnement minimum (*q̇*|*₂ₘᵢₙ*) autorisé par le condenseur (23), et
comprenant en outre l'étape :
- lorsque l'ensemble de déviation est dans le premier état, sélectionner (617) le débit le plus élevé parmi :
- un débit de fonctionnement minimum (*q̇*|*₃ₘᵢₙ*) autorisé par l'échangeur de chaleur (31) ;
- un débit de fonctionnement minimum (*q̇*|*₁ₘᵢₙ*) autorisé par l'échangeur de chaleur supplémentaire (11),
- un débit de fonctionnement minimum (*q̇*|*₂ₘᵢₙ*) autorisé par le condenseur (23).

11. - Procédé (600 ; 700) selon l'une quelconque des revendications précédentes 7 à 10, dans lequel le premier ensemble de pompage comprend deux pompes (32a, 32b) reliées ensemble en parallèle, tandis que l'ensemble de déviation (34) comprend une première vanne (34a) reliée hydrauliquement en série à une sortie de refoulement des deux pompes (34a, 34b) et en parallèle aux orifices d'entrée et de sortie de l'échangeur de chaleur (31) à travers lesquels le premier fluide s'écoule, et une seconde vanne (34b) reliée hydrauliquement en série à la sortie de refoulement des deux pompes (34a, 34b) et en série à l'orifice d'entrée de l'échangeur de chaleur (31) à travers lequel le premier fluide s'écoule, et
le procédé (700) comprenant les étapes supplémentaires :
- identifier (701) un dysfonctionnement de l'une des pompes (32a, 32b) du premier ensemble de pompage (32), et
- lorsqu'un dysfonctionnement est identifié, amener progressivement (625) la première vanne (34a) et la seconde vanne (34b) à un état partiellement ouvert afin de réduire les chutes de pression subies par la pompe en fonctionnement (32a, 32b).
